Europäisches Patentamt

**European Patent Office** (11) Numéro de publication: **0 130 262 B1**

Office européen des brevets

(12) **FASCICULE DE BREVET EUROPEEN**

(45) Date de publication du fascicule du brevet: **19.11.87**

(51) Int. Cl.⁴: **H 03 K 19/084,** H 03 K 19/088

(21) Numéro de dépôt: **83430022.0**

(22) Date de dépôt: **30.06.83**

(54) **Circuits logiques permettant de constituer des réseaux logiques très denses.**

(43) Date de publication de la demande:
**09.01.85 Bulletin 85/2**

(45) Mention de la délivrance du brevet:
**19.11.87 Bulletin 87/47**

(84) Etats contractants désignés:
**DE FR GB IT**

(56) Documents cités:
**EP - A - 0 011 700**
**FR - A - 2 234 713**

IBM TECHNICAL DISCLOSURE BULLETIN, vol. 21, no. 3, Août 1978, New York S.W. GIULIANI et al., "Three-state driver", page 1072
IBM TECHNICAL DISCLOSURE BULLETIN, no. 21, no. 11, Avril 1979, New York M. BATTISTA et al. "INTEGRATED logic circuit", pages 4515, 4516
IBM TECHNICAL DISCLOSURE BULLETIN, vol. 25, no. 1, Juin 1982, New York H. BERANGER "N-Way and circuit and multiplex circuit for T2L family", pages 334-335
IBM TECHNICAL DISCLOSURE BULLETIN, vol. 19, no. 9, Février 1977, New York W.S. KLARA et al. "Cascode T2L circuit", pages 3428, 3429
IBM TECHNICAL DISCLOSURE BULLETIN, vol. 21, no. 5, Août 1978, New York R.T. FARLEY et al. "Address decoder without a true-complement generator", page 1909

(73) Titulaire: **International Business Machines Corporation, Old Orchard Road, Armonk, N.Y. 10504 (US)**
(84) Etats contractants désignés: **DE GB IT**

(73) Titulaire: **Compagnie IBM FRANCE, 5 Place Vendôme, F-75000 Paris 1er (FR)**
(84) Etats contractants désignés: **FR**

(72) Inventeur: **Brunin, Armand, 61, Allée de Bretagne, F-77350 Le Mée Seine (FR)**
Inventeur: **Denis, Bernard, 17 Rue des Framboises, F-91540 Mennecy (FR)**
Inventeur: **Boudon, Gérard, 5 Rue des Coudriers, F-91540 Mennecy (FR)**
Inventeur: **Mollier, Pierre, 15 Rue de Ponthierry, F-77310 Boissise le Roi (FR)**
Inventeur: **Stoppa, Philippe, 218 Avenue Daumesnil, F-75012 Paris (FR)**

(74) Mandataire: **Lattard, Nicole, Compagnie IBM France Département de Propriété Intellectuelle, F-06610 La Gaude (FR)**

## Description

La présente invention concerne un circuit logique de base à partir duquel peut être développée une famille de circuits logiques qui permet de réaliser des réseaux logiques à très haute densité.

Etat de la Technique

Actuellement, les systèmes de traitement de l'information sont en grande partie constitués de réseaux logiques prédiffusés. Pour diminuer le coût de tels systèmes, il faut faciliter la conception de ces réseaux.

Pour ce fair, on peut réaliser des réseaux à base de cellules universelles du type de celles décrites dans la demande de brevet français publiée sous le numéro 2 441 969.

Cette cellule est réalisée à partir de circuits logique type ECL (Emitter Coupled Logic), et en conséquence son utilisation est réservée à la constitution de réseaux exigeant des vitesses de fonctionnement élevées sans nécessiter une grande densité d'intégration.

Généralement, pour ce type d'application, on utilise des microplaquettes dans lesquelles sont diffusées des cellules de base réalisant une fonction logique élémentaire, par exemple, NON ET. La microplaquette est ensuite personnalisée, c'est-à-dire que les cellules sont connectées entre elles, de façon appropriée pour constituer le réseau désiré.

La cellule de base comportant une porte TTL (Transistor-Transistor Logic) du type décrit dans le brevet français publié sous le numéro 2 234 713 a l'inconvénient d'être lente et ne permet pas d'obtenir une densité suffisamment élevée. En effet, la réalisation de certaines fonctions à partir de cette porte NON ET nécessite un grand nombre de cellules.

La cellule de base comportant une porte DTL (Diode Transistor Logic), outre l'inconvénient de la faible densité, présente celui d'avoir une faible immunité au bruit à cause du faible niveau de commutation.

Les technologies actuelles permettent de réaliser des réseaux intégrés avec quatre niveaux de métallisation. En conséquence, il n'est plus nécessaire que les cellules constitutives du réseau, généralement disposées en matrice, soient séparées pour laisser la place aux connexions intercellules, celles-ci se faisant désormais aux différents niveaux de métallisation. Par exemple, les éléments de la cellule peuvent être connectés au premier niveau, les canaux de cablage verticaux peuvent être prévus au second niveau, et les canaux de cablage horizontaux peuvent être prévus au troisième niveau.

La surface de la cellule est déterminée en fonction du nombre de cellules à câbler par le pas de répétition des canaux de cablage horizontaux et verticaux.

En conséquence, on ne peut plus augmenter la densité d'intégration des réseaux logiques constitués à base de portes NON ET classiques du fait que chaque cellule doit occuper une surface déterminée.

Le circuit décrit dans l'article publié dans l'IBM Technical Disclosure Bulletin, vol. 25, no. 1, juin 1982, page 334 est un circuit qui contrairement aux circuits DTL classiques est constitué à l'aide de diodes de Schottky à barrière élevée. A cause de la chute de tension élevée dans ces diodes, il est nécessaire de connecter l'émetteur du transistor d'entrée à une tension de référence de valeur choisie très précisément pour permettre le blocage des transistors T1 et T2. Ce circuit présente une immunité au bruit qui est compatible avec celle des circuits T2L classiques mais pas meilleure.

Un objet de la présente invention est donc de réaliser un circuit logique de base qui permette de constituer une cellule de type universel capable de réaliser un grand nombre de fonctions.

Un autre objet de la présente invention est de réaliser un tel circuit logique qui permette d'améliorer le facteur coût/performance des microplaquettes de réseaux logiques.

Un autre objet de la présente invention est de réaliser un tel circuit qui permette de constituer des réseaux logiques à haute densité d'intégration avec de faibles alimentations de tension.

Résumé de l'Invention

Le circuit élémentaire conforme à la présente invention permet de réaliser une fonction logique de base à partir de n signaux d'entrée A, B . . . et potentiellement d'un signal d'entrée supplémentaire X. Il comprend n diodes d'entrée de Schottky à faible barrière (D1 à DN) ayant des premières électrodes recevant chacune un des n signaux d'entrée et des secondes électrodes connectées à un nœud commun relié par une résistance à une première alimentation de tension de faible valeur (+1,7 volt), et un transistor d'entrée qui a sa base connectée au nœud commun, dont le collecteur est connecté par une résistance à la première tension d'alimentation et dont l'émetteur peut être connecté à une tension de référence dont la valeur est égale au niveau bas des signaux d'entrée pour obtenir un circuit présentant une bonne immunité au bruit, ou pouvant recevoir un signal d'entrée supplémentaire X lorsque l'immunité au bruit n'est pas critique. Un transistor inverseur de sortie a sa base connectée au collecteur du transistor d'entrée, son émetteur relié à une seconde alimentation de tension (0 volt) et son collecteur connecté par une résistance à la première tension d'alimentation, de telle sorte que le niveau logique obtenu au collecteur du transistor de sortie représente la fonction (AB C . . .) ou $\overline{X}$ (AB . . .) suivant que l'émetteur du transistor d'entrée est connecté à la tension de référence ou reçoit le signal d'entrée supplémentaire.

A partir de ce circuit élémentaire, on peut construire une famille de circuits logiques qui pourra être appelée DTTL (Diode Transistor Transistor Logic) car les circuits se comportent à la fois comme des circuits DTL et des circuits TTL. Chaque circuit logique peut être constitué de plusieurs circuits élémentaires ou peut être constitué en disposant dans un circuit élémentaire plusieurs transistors d'entrée. Le signal d'entrée supplémentaire peut être appliqué sur tous les émetteurs de transistors d'entrée ou des signaux supplémentaires différents peuvent être appliqués aux émetteurs des transistors. Les bases des transistors d'entrée sont connectées à une ou plusieurs diodes d'entrée sur lesquelles sont appliqués les signaux d'entrée (A, B, C, D . . .).

Les circuits logiques de la famille sont constitués dans une cellule universelle comportant des éléments semi-conducteurs: diodes, transistors et résistances implantées, prédiffusés, de telle sorte que par cablage au premier niveau de métallisation des éléments appropriés, on puisse constituer tous les circuits de la famille. Les cellules sont ensuite interconnectées entre elles aux second et troisième niveaux de métallisation pour former des réseaux logiques très denses et très performants.

Brève description des Figures

Les figures 1A et 1B représentent les circuits élémentaires DTTL conformes à la présente invention.

La figure 2 représente un premier circuit de la famille logique DTTL réalisant la fonction logique $\bar{X}(AB+CD)$ ou $(AB+CD)$.

La figure 3 représente un second circuit de la famille logique DTTL réalisant la fonction logique $AB\bar{X}+CD\bar{Y}$.

La figure 4 représente un troisième circuit de la famille logique DTTL réalisant la fonction logique $(AB\bar{X}).(CD\bar{Y})$.

Les figures 5A et 5B représentent une cellule universelle permettant de constituer les circuits de la famille logique.

Les figures 6A à 10A représentent les connexions nécessaires pour constituer dans la cellule les circuits des 6B à 10B.

La figure 11 représente le schéma global d'un multiplicateur.

La figure 12A représente les connexions nécessaires pour réaliser en trois cellules le circuit de multiplication de la figure 12B, constituant un élément du multiplicateur de la figure 11.

Description détaillée de l'Invention

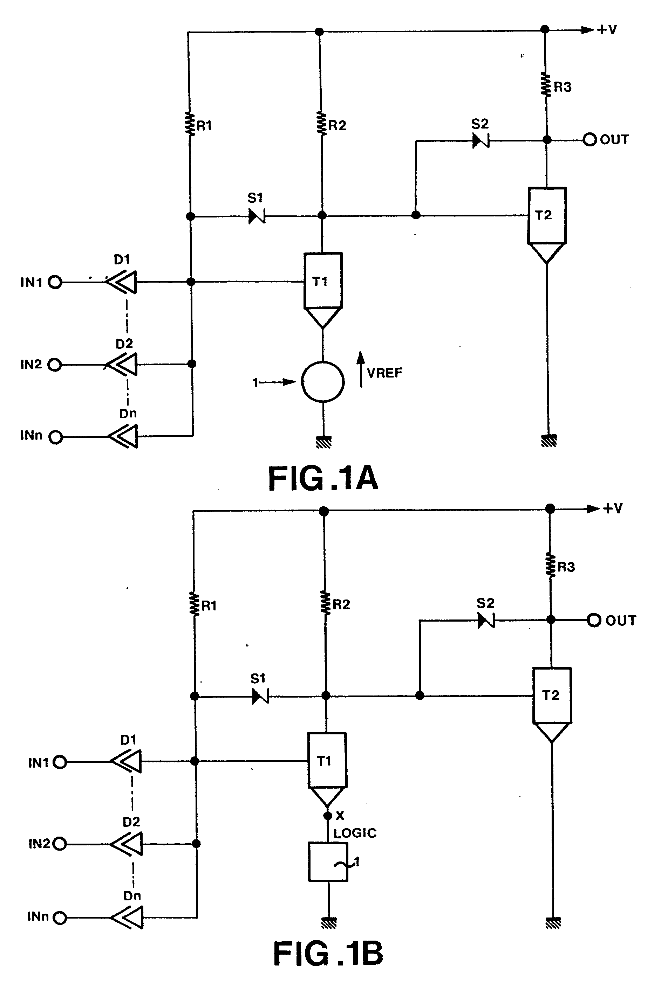

Le circuit logique de base est représenté sur les figures 1A et 1B, il constitue une porte ET à partir de laquelle pourra être développée une famille logique d'un type qui sera appelé DTTL (Diode Transistor Transistor Logic).

Il comprend des diodes de Schottky à faible barrière D1, D2;...Dn. Les cathodes de ces diodes constituent les bornes d'entrée IN1, IN2...INn du circuit sur lesquelles sont appliqués des signaux d'entrée A, B . . .etc.

Les anodes sont connectées en commun à la base d'un transistor d'entrée de typ NPN T1, d'une part et par l'intermédiaire d'une résistance implanté R1 à la tension d'alimentation +V d'autre part. Dans un mode de réalisation préféré, la tension +V est choisie égale à 1,7 volts.

Le collecteur du transistor T1 est connecté à la tension d'alimentation +V par une résistance implantée R2 et son émetteur est connecté à la masse par un circuit 1. Le collecteur du transistor T1 est connecté à la base d'un transistor de sortie T2 inverseur.

L'émetteur du transistor T2 est connecté à la masse et son collecteur est connecté à la tension d'alimentation +V par une résistance implantée R3.

Le signal de sortie du circuit est pris à la borne de sortie OUT au collecteur du transistor T2.

Deux diodes de Schottky d'antisaturation S1 et S2 à barrière élevée sont disposées entre le collecteur et la base des transistors T1 et T2.

La particularité de ce circuit tient au fait que l'émetteur du transistor T1 est connecté à la masse par l'intermédiaire du circuit 1.

Ce circuit peut être constitué par une source de tension de référence VREF égale à la tension collecteur émetteur VCE d'un transistor NPN soit 0,3 volt, comme représenté sur la figure 1A, ou il peut être constitué par un autre circuit logique dont le signal de sortie X est appliqué à l'émetteur du transistor T1 comme représenté sur la figure 1B.

Ainsi, on peut constituer des ensembles logiques de type cascode comme cela sera décrit ultérieurement, et de ce fait augmenter la puissance logique du circuit de base de la figure 1A.

Lorsqu'au moins un des signaux sur les entrées IN1 à INn est à un niveau bas, c'est-à-dire inférieur à un seuil Vt de préférence égal à 0,3 volt soit la tension VCE d'un transistor, la ou les diodes d'entrée D1 à Dn correspondantes sont polarisées dans le sens direct et en conséquence le transistor T1 est bloqué. La tension au collecteur de T1 étant au niveau haut, le transistor T2 est conducteur et le niveau du signal de sortie est bas égal à la tension collecteur-émetteur VCE du transistor T2.

Lorsque les signaux sur les entrées IN1 à INn sont à un niveau haut, les diodes d'entrée sont bloquées et le transistor T1 est conducteur, ce qui provoque le blocage du transistor T2 le niveau du signal de sortie est donc haut.

Le circuit de base de la figure 1A réalise donc la fonction ET des signaux appliqués à ses entrées.

La tension de seuil est égal à:

$$VREF+VBE(T1)-VS \simeq 0,3+0,8-0,3 \simeq 0,8 \text{ volt}$$

VBE (T1) représente la tension base émetteur du transistor T1 et la tension VS représente la tension aux bornes d'une diode de Schottky lorsqu'elle est polarisée dans le sens direct.

L'immunité au bruit VIM du circuit est égal à:

$$VT-VIN \simeq VT-VCE \simeq 0,5 \text{ volt}$$

Elle est donc deux fois supérieure à l'immunité au bruit des circuits conventionnels de type DTL ou TTL.

Ceci permet d'augmenter de façon importante le nombre des entrées et sorties et de faciliter la conception des réseaux logiques.

Le fonctionnement du circuit de la figure 1B est le suivant:

Le signal X représente le résultat d'une fonction logique réalisée par le circuit 1. Ce circuit étant du même type que le circuit de la figure 1A, le niveau du signal X est soit égal à VCE (niveau bas) soit égal à environ 1,7 volt (niveau haut).

Si X a un niveau bas égal à VCE, le circuit de la figure 1B fonctionne de la même façon que celui de la figure 1A et fournit un signal de sortie qui dépend des niveaux sur les entrées IN1 à INn.

Si X a un niveau haut, quels que soient les niveaux des signaux sur les entrées IN1 à INn, le transistor T1 ne sera jamais conducteur et en conséquence la sortie sera toujours au niveau bas.

Le circuit de la figure 1B réalise donc la fonction logique:

$(AB\ldots)\overline{X}$

On va maintenant montrer comment en partant de ce circuit de base on peut développer une famille de circuits logiques.

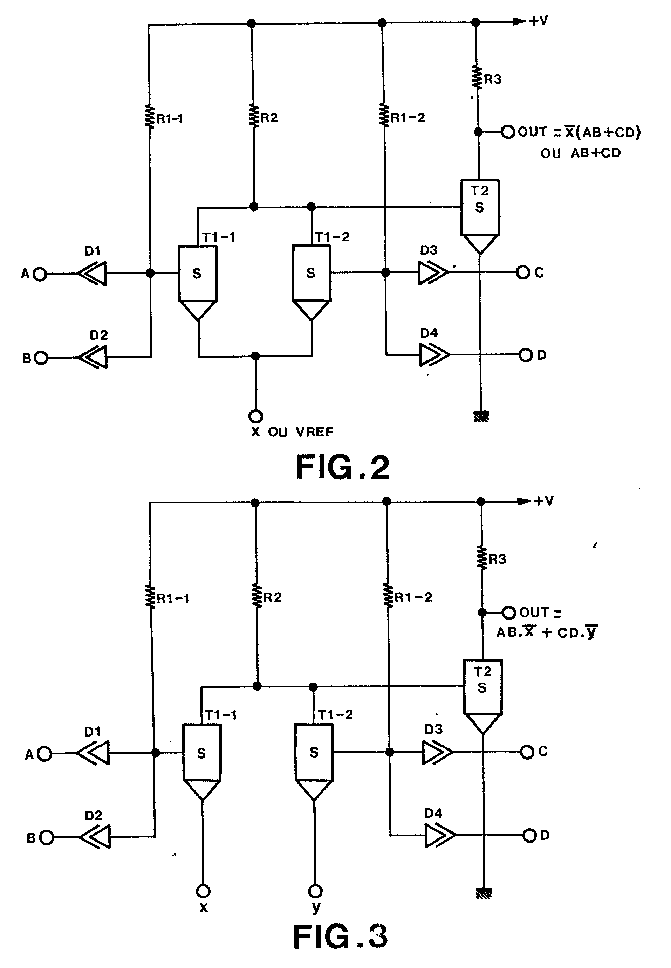

Trois circuits de la famille sont représentés sur les figures 2, 3 et 4 à titre d'exemple.

Le circuit de la figure 2 comporte deux transistors d'entrée T1–1 et T1–2, munis de diodes de Schottky d'antisaturation (ce qui est représenté symboliquement par un S dans le schéma du transistor) et quatre diodes de Schottky d'entrée à faible barrière D1, D2, D3 et D4.

Les diodes D1 et D2 reçoivent sur leurs cathodes deux signaux d'entrée A et B et ont leurs anodes connectées à la base du transistor T1–1. Les diodes D3 et D4 reçoivent sur leurs cathodes deux signaux d'entrée C et D et ont leurs anodes connectées à la base du transistor T1–2.

Les bases de T1–1 et de T1–2 sont connectées à la tension d'alimentation +V par des résistances R1–1 et R1–2 respectivement. Les collecteurs de T1–1 et T1–2 sont connectés en commun et reliés à la tension d'alimentation +V par une résistance R2 et sont connectés à la base du transistor de sortie inverseur T2, dont le collecteur est connecté à la tension +V par la résistance R3 et l'émetteur est connecté à la masse, comme dans le circuit de la figure 1A ou 1B.

Supposons que la tension sur les émetteurs des transistors T1–1 et T1–2 soit égale à VREF ou que X soit au niveau bas.

Si l'un des signaux d'entrée sur A et B et sur C et D est au niveau bas ou que tous les signaux d'entrée A, B, C et D sont au niveau bas, les transistors T1–1 et T1–1 sont bloqués et donc le transistor de sortie T2 est conducteur donc le signal de sortie est au niveau bas.

Si les signaux d'entrée A, B, C et D sont au niveau haut, les transistors T1–1 et T1–2 sont conducteurs et donc T2 est bloqué, donc le signal de sortie est au niveau haut.

Si l'un ou l'autre des signaux A ou B est au niveau bas et que C et D sont au niveau haut, T1–1 est bloqué et T1–2 est conducteur dont T2 est bloqué et le signal de sortie est au niveau haut.

Si l'un ou l'autre des signaux C ou D est au niveau bas et que A et B sont au niveau haut T1–2 est bloqué et T1–1 est conducteur donc T2 est bloqué et le signal de sortie est au niveau haut.

Si par contre X est au niveau haut, quels que soient les niveaux des signaux d'entrée A, B, C et D, les transistors T1–1 et T1–2 seront toujours bloqués et le transistor T2 sera conducteur. Le niveau du signal de sortie sera bas.

En conséquence suivant que les émetteurs des transistors T1–1 et T1–2 sont connectés à la sortie X d'un circuit logique ou à la tension VREF, le circuit de la figure 2 réalise la fonction $\overline{X}$ (AB+CD) ou AB+CD.

Le circuit de la figure 3 est identique à celui de la figure 2 sauf que les émetteurs des deux transistors T1–1 et T1–2 ne sont pas reliés ensemble mais reçoivent les signaux de sortie X et Y venant d'autres circuits logiques, et en conséquence il réalise la fonction logique AB$\overline{X}$+CD$\overline{Y}$.

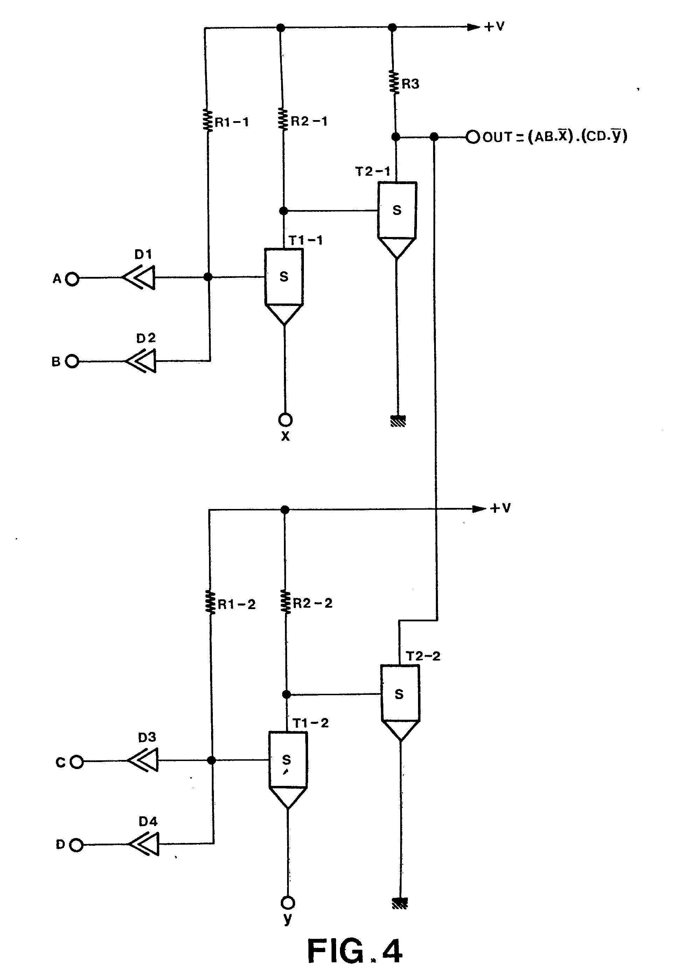

Le circuit de la figure 4 est constitué de deux circuits de la figure 1B. Il comporte deux transistors d'entrée T1–1 et T1–2 et deux transistors de sortie T2–1 et T2–2.

Les transistors d'entrée T1–1 et T1–2 ont leurs bases reliées aux anodes des diodes d'entrée D1, D2 et D3, D4 comme dans l'arrangement de la figure 3. Les cathodes des diodes D1 à D4 reçoivent les signaux d'entrée A, B, C et D respectivement. Les anodes des diodes D1 et D2 sont connectées à la tension d'alimentation +V par la résistance R1–1 et les anodes des diodes D3 et D4 sont connectées à la tension d'alimentation +V par la résistance R1–2.

Le collecteur du transistor T1–1 est connecté à la base du premier transistor de sortie T2–1 et le collecteur du transistor T1–2 est connecté à la base du second transistor de sortie T2–2. Les collecteurs des transistors T2–1 et T2–2 sont connectés en commun à la tension +V par une résistance R3.

La sortie OUT est prise aux collecteurs communs des deux transistors de sortie de telle sorte que le circuit de la figure 4 réalise la fonction logique (AB$\overline{X}$).(CD$\overline{Y}$).

D'autres arrangements peuvent être constitués de telle sorte que le circuit de base des figures 1A ou 1B permette le développement de toute une famille de circuits logiques, qui en plus d'avoir l'avantage d'une très grande immunité au bruit permette de réaliser des ensembles logiques ayant une puissance logique accrue. En effet X et Y représentant une fonction complexe, c'est-à-dire étant le résultat d'une fonction logique quelconque de plusieurs variables d'entrée, on peut réaliser des réseaux logiques avec des connexions de longueur minimum en disposant plusieurs étages de circuits suivant une configuration de type cascode.

Pour faciliter la conception de réseaux logiques à partir de cette famille logique DTTL, on utilise une microplaquette comprenant des cellules de type universel disposées de façon classique en rangées et colonnes. Dans chacune des cellules sont prédiffusés des éléments semi-conducteurs: diodes transistors et des résistances qui ne sont pas connectés entre eux.

Par personnalisation de la microplaquette, c'est-à-dire par personnalisation de chaque cellule en connectant les éléments entre eux, pour que la cellule réalise une fonction déterminée et par connexion des cellules entre elles, le réseau logique désiré est constitué.

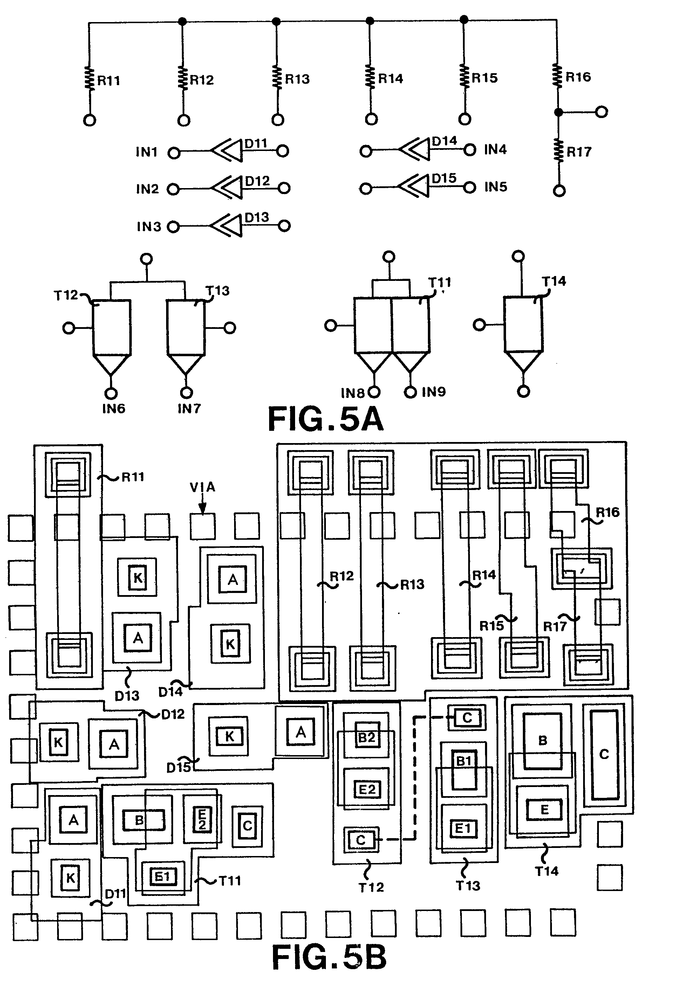

Dans un mode de réalisation préféré, représenté sur la figure 5A, la cellule contient cinq diodes de Schottky à faible barrière D11 à D15, dont les cathodes constitueront les entrées des circuits logiques, sept résistances implantées R11 à R17 et quatre transistors T11 à T14 parmi lesquels T11 est un transistor à double émetteur.

Ces éléments sont prédiffusés de façon appropriée à l'intérieur de la cellule, comme représenté sur la figure 5B qui constitue une vue de la cellule dans le plan du premier niveau de métallisation. Leur disposition dans le silicium de la microplaquette est telle que les connexions entre les éléments soient de longueur minimum, quel que soit le type de circuit de la famille qui sera réalisé dans la cellule. Une grille de 9×13 vias possibles est prévue dans chaque cellule. Les vias sont représentés par des carrés sur la figure 5B.

Les anodes des diodes de Schottky sont repérées par la lettre A et les cathodes par la lettre K. Les bases, émetteurs et collecteurs des transistors sont repérés par les lettres B, E et C respectivement. Les diodes de Schottky d'antisaturation, montées entre le collecteur et la base des transistors T11 à T14 ne sont pas représentées.

Afin de réaliser un réseau logique, chaque cellule est personnalisée en disposant les contacts appropriés aux éléments prédiffusés et un cablage au premier niveau de métallisation pour connecter les éléments entre eux afin que la cellule réalise une fonction logique avec des entrées-sorties I/O accessibles par plusieurs bornes LST (Logic Service Terminal) disposées à des points appropriés dans la grille de 9×13 vias ainsi que cela est représenté sur les figures montrant quelques exemples de personnalisation.

Le cablage entre les cellules est ensuite réalisé aux second et troisième niveaux de métallisation.

Pour constituer le cablage global du réseau, vingt-quatre canaux de cablage sont disponibles pour chaque cellule:

9 canaux de cablage horizontaux au troisième niveau de métallisation,

13 canaux de cablage verticaux au second niveau de métallisation,

2 canaux de cablage horizontaux au premier niveau de métallisation, réservés à des lignes de commande.

La première étape de la conception d'un réseau logique consiste à définir le premier niveau de métallisation.

Pour chaque borne I/O, on définit une borne LST primaire et plusieurs secondaires. Lorsque toutes les fonctions logiques différentes sont placées dans la grille de cellules sur la microplaquette, un programme de cablage automatique classique définit les interconnexions entre les bornes d'entrée/sortie primaires.

Lorsque le cablage est impossible, une borne secondaire est choisie. Seul un via parmi le nombre total de vias définis pour une borne d'entrée/sortie I/O est utilisé, les autres n'étant pas réalisés dans la cellule finale ainsi personnalisée, les câblages peuvent passer sur ces vias non utilisés sans faire contact aux bornes d'entrée/sortie.

Ce procédé donne plus de liberté pour le cablage et permet de limiter la longueur, la capacité et la résistance des conducteurs qui interconnectent les cellules.

Toutes les fonctions logiques qu'il est possible de réaliser à partir d'une ou plusieurs cellules universelles sont précâblées pour constituer, dans un système de conception automatique assisté par ordinateur CAD, une librairie de cellules qui sera à la disposition du concepteur de réseaux logiques. Ces cellules peuvent être arrangées par des programmes de mise en place automatique et de cablage pour former le réseau, conformément aux enseignements du brevet européen 79103921.7 (EP-A-0 011 700).

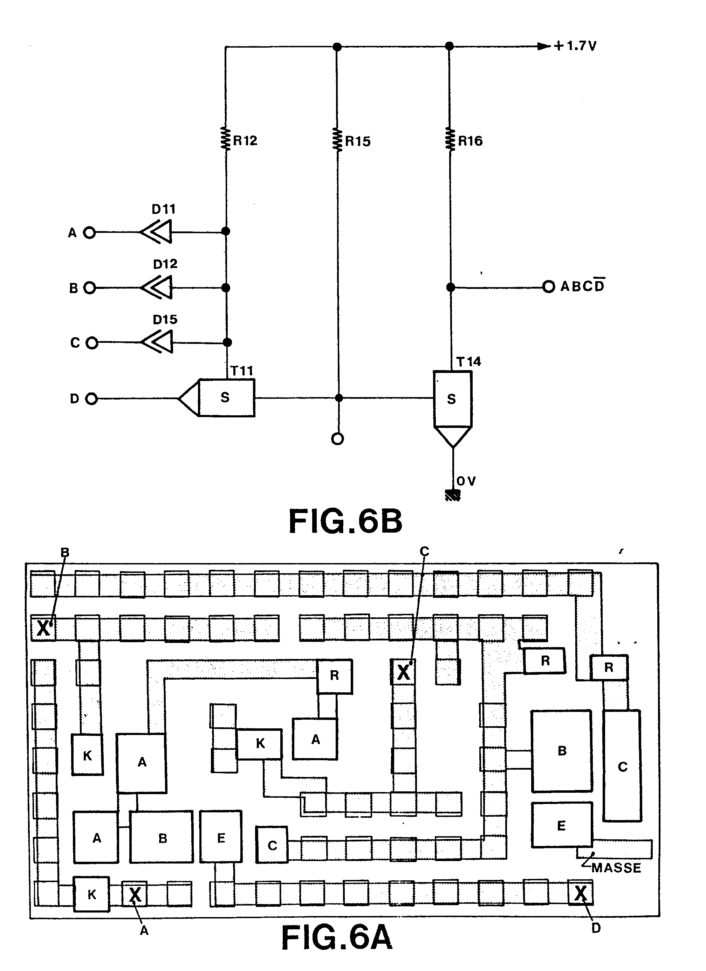

De nombreuses fonctions peuvent être réalisées, une liste non exhaustive est donnée ci-après. Le cablage pour obtenir ces fonctions peut être réalisé facilement par l'homme de métier à partir de la description précédente. Un exemple de cablage pour certaines fonctions sera donné en référence aux figures 6 à 10.

| fonctions deux entrées A et B | fonctions trois entrées A, B et C |
|---|---|
| $\overline{A}\overline{B}$ | $\overline{ABC}$ |
| $A\overline{B}$ | $A(\overline{B}+\overline{C})$ |
| $AB$ | $AB\overline{C}$ |
| $A+\overline{B}$ | $\overline{A}B+C$ |
| $A+B$ | $A\overline{B}+C$ |
| $AB+\overline{A}\overline{B}$ | $A\overline{B}+\overline{C}$ |
| $AB+\overline{A}\overline{B}$ | $AB+C$ |
| | $A\overline{B}+C$ |
| | $AB+C$ |
| | $\overline{A}+B+C$ |
| | $A+B+C$ |

| fonctions quatre entrées A B C et D | |
|---|---|
| $\overline{ABCD}$ | $A\overline{B}+\overline{C}D$ |
| $A(\overline{B}+\overline{C}+\overline{D})$ | $AB\overline{C}+D$ |
| $\overline{A}(B+C+D)$ | $A\overline{B}+CD$ |
| $AB(\overline{C}+\overline{D})$ | $AB+CD$ |
| $ABC\overline{D}$ | $ABC+\overline{D}$ |
| $ABCD$ | $A\overline{B}+C+\overline{D}$ |
| $A(\overline{B}+\overline{C})+\overline{D}$ | $A\overline{B}+C+D$ |
| $\overline{A}\overline{B}C+D$ | $AB+C+\overline{D}$ |
| $\overline{A}B+\overline{C}D$ | $AB+C+D$ |
| $AB\,\overline{C}+D$ | $AB+\overline{C}+\overline{D}$ |
| | $A\overline{B}+\overline{C}+\overline{D}$ |

Sur la figure 6A sont représentées par les parties ombrées, les connexions nécessaires pour personnaliser une cellule afin de réaliser la fonction du circuit de la figure 1B avec quatre entrées.

Le schéma équivalent est donné sur la figure 6B dans laquelle les éléments semi-conducteurs de la cellule de la figure 5B ont été référencés par les mêmes numéros.

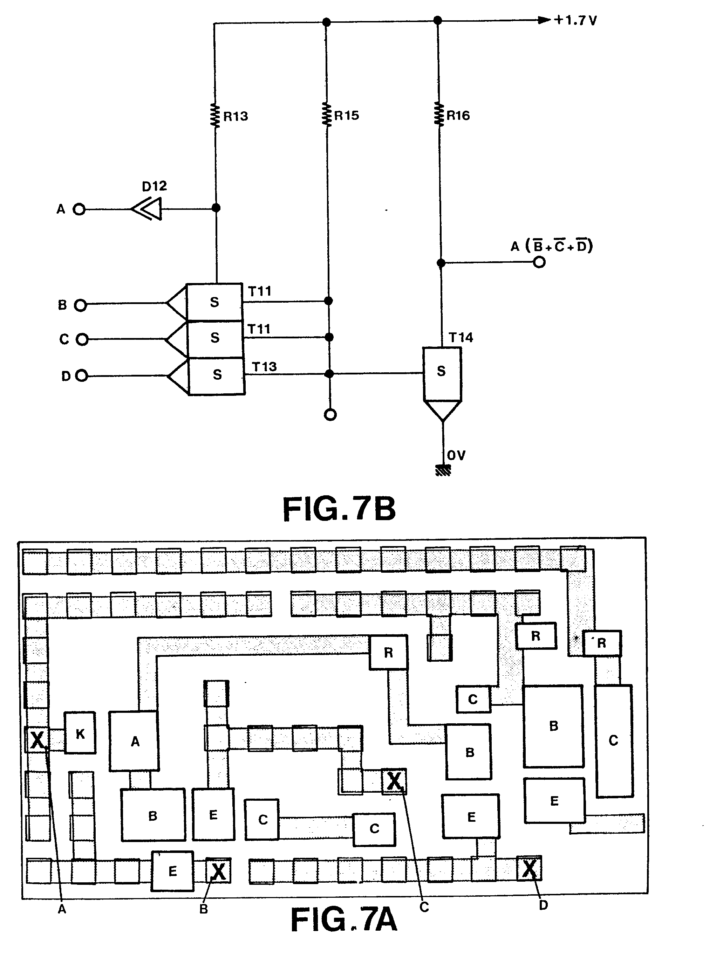

De la même façon, sur la figure 7A, sont représentées les connexions nécessaires pour la personnalisation d'une cellule réalisant de la fonction $A(\overline{B}+\overline{C}+\overline{D})$.

Cette cellule comporte une diode d'entrée D12 recevant le signal logique A et trois transistors d'entrée constitués par le transistor à double émetteur T11 et, le transistor T13 dont le collecteur est relié au collecteur de T12, comme représenté en pointillés sur la figure 5B.

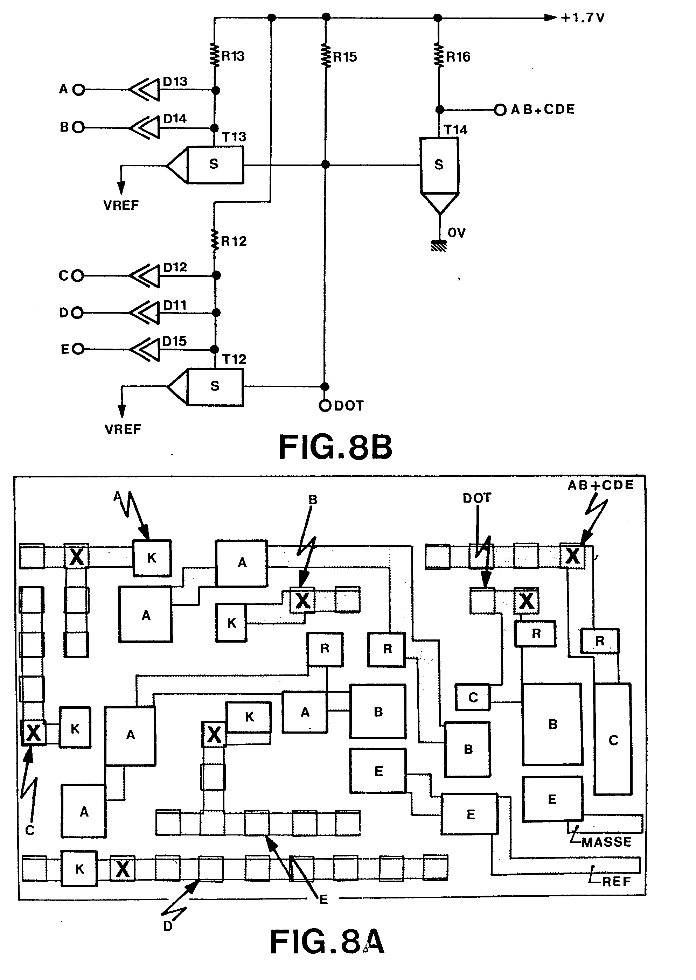

Sur la figure 8A sont représentées les connexions nécessaires pour la personnalisation d'une cellule réalisant la fonction AB+CDE, lorsque les émetteurs des transistors T13 et T12 sont connectés à la tension de référence comme représenté sur le schéma équivalent à la figure 8B. Lorsque l'émetteur de T13 reçoit la sortie X d'une autre cellule et l'émetteur de T12 reçoit la sortie Y d'une autre cellule, la cellule de la figure 8A réalise la fonction $\overline{X}$ AB+ $\overline{Y}$ CDE. Lorsque les émetteurs de T13 et T14 sont connectés ensemble et reçoivent la sortie X d'une autre cellule, la cellule de la figure 8A réalise la fonction $\overline{X}$ (AB+CDE).

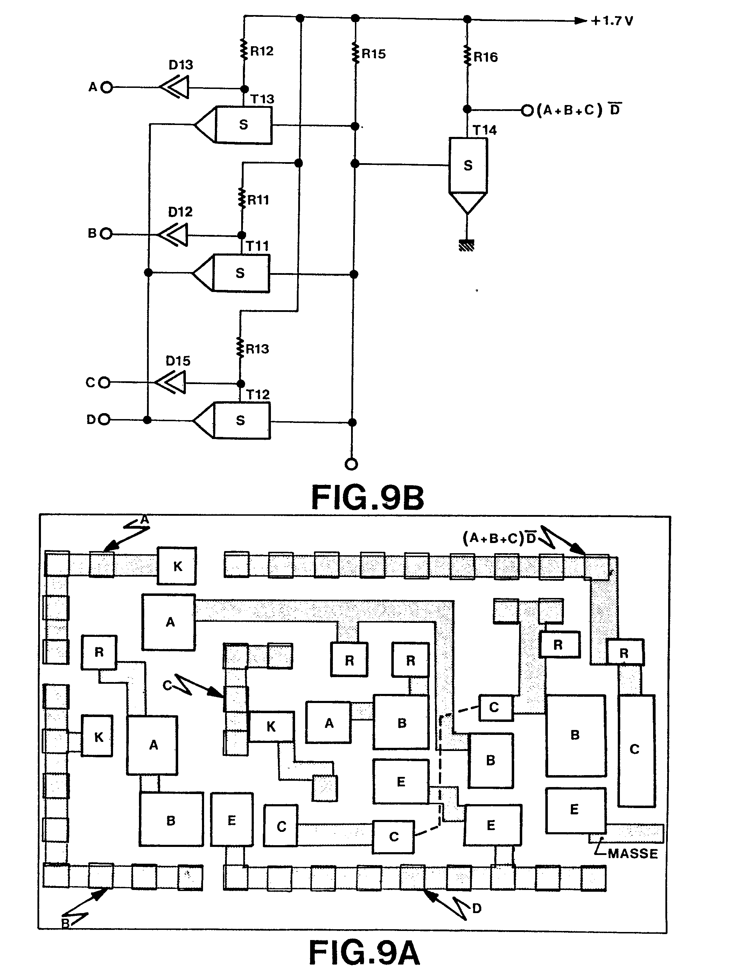

Sur la figure 9A sont représentées les connexions nécessaires pour la personnalisation d'une cellule réalisant la fonction (A+B+C) $\overline{D}$. Le schéma équivalent est donné sur la figure 9B.

De nombreuses autres configurations de cablage peuvent être envisagées pour réaliser une très grande variété de fonctions logiques ou autres circuits logiques tels que divers types de bascules.

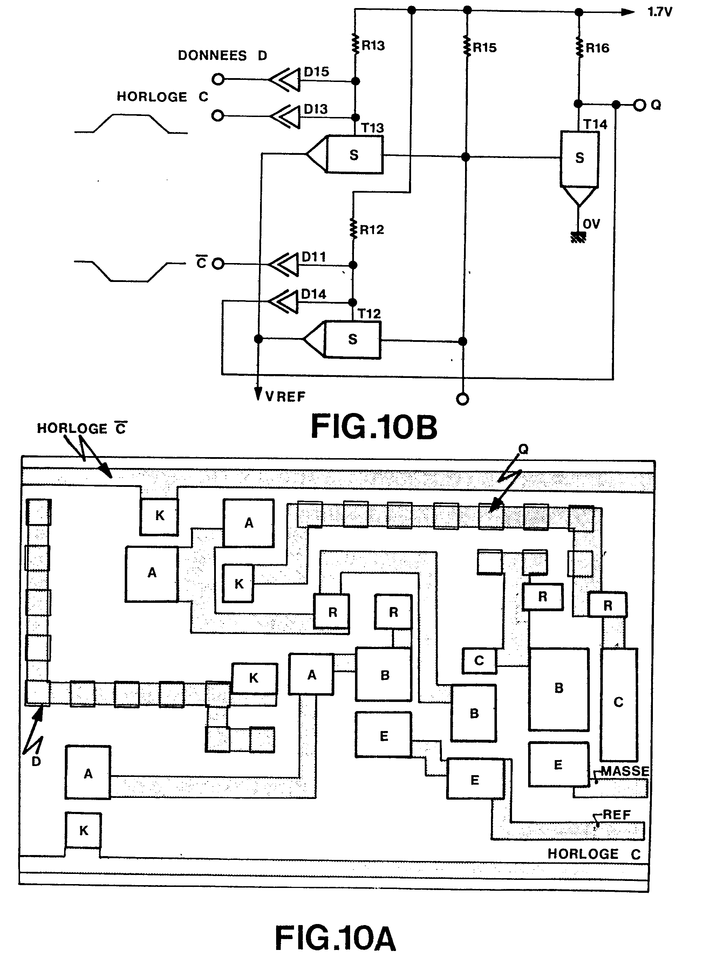

Un exemple de connexions qui permettent de réaliser une bascule est représenté sur la figure 10A. Le schéma équivalent est donné sur la figure 10B.

En connectant ensemble plusieurs cellules, des circuits, réalisant des fonctions logiques complexes, qui sont souvent utilisés dans les réseaux logiques peuvent être constitués et mis dans la librairie de circuits à la disposition du concepteur.

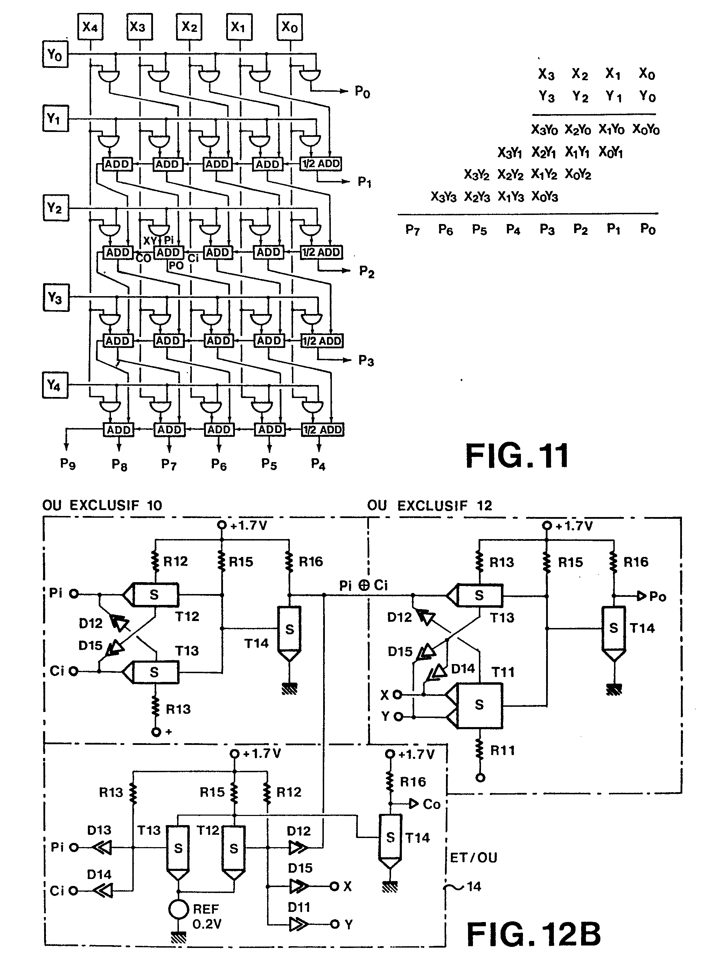

A titre d'exemple, on montrera en référence aux figures un circuit multiplicateur/additionneur réalisé avec trois cellules, pouvant entrer dans la constitution d'un multiplicateur tel que représenté sur la figure 11. Ce multiplicateur réalise la multiplication d'un multiplicande X3 X2 X1 X0 et d'un multiplicateur Y3 Y2 Y1 Y0 pour fournir le produit P7 P6 P5 P4 P3 P2 P1 P0 comme indiqué sur la figure.

Il comprend des portes ET (représentées par des demi-cercles) et des additionneurs complets ou demi-additionneurs référencés ADD et 1/2 ADD. Cette disposition est classique et ne fait pas partie de la présente invention, elle n'est donnée que pour montrer comment pourra être utilisé le circuit de la figure qui représente un circuit multiplicateur comprenant le circuit ET et l'additionneur ADD recevant les produits X Y de deux bits des multiplicande et multiplicateur X et Y, le facteur Pi venant d'un additionneur ADD de l'étage supérieur et le report Ci venant de l'additionneur ADD de droite. Chaque additionneur génère les facteurs Po et Co qui constituent les facteurs Pi et Ci destinés à l'étage inférieur et à l'additionneur de gauche, comme on peut le voir sur la figure 11.

Les facteurs Po et Co sont les résultats des fonctions logiques suivantes:

$$Po=(Pi \otimes Ci) \otimes X Y$$
$$Co=PiCi + X Y (Pi \otimes Ci)$$

En conséquence, l'additionneur ADD comme représenté sur la figure 12B comprend un premier circuit OU exclusif 10 comportant les transistors T12 et T13 de la cellule, les diodes D12 et D15, le transistor de sortie T14 et les résistances R12, R13, R15 et R16.

Ce circuit reçoit comme entrées: le facteur Pi sur l'émetteur de T12 et la cathode de la diode D12 et le report Ci sur l'émetteur de T13 et la cathode de D15.

L'anode de la diode D12 est connectée à la base de T13, et l'anode de la diode D15 est connectée à la base de T12. Les bases des transistors T12 et T13 sont connectées à la tension d'alimentation +V=1,7 volt par les résistances R12 et R13 respectivement. Le collecteur commun des transistors T12 et T13 est connecté par la résistance R15 à la tension +V et est connecté à la base au transistor de sortie T14. L'émetteur de T14 est connecté à la masse et son collecteur est connecté à la tension +V par la résistance R16.

Ce circuit constitue un circuit OU exclusif classique, donc la sortie au collecteur de T14 est égale à Pi $\otimes$ Ci.

Un second circuit OU exclusif 12 à trois entrées est réalisé dans une deuxième cellule, et comporte une disposition similaire à celle du circuit 10.

Il est fait usage des transistors T13 et T14 ainsi que du transistor T11 à double émetteur, sur lesquels sont appliqués les signaux d'entrée X et Y.

L'émetteur du transistor T13 est connecté à la sortie Pi $\otimes$ Ci de la cellule 10.

La diode D12 a sa cathode connectée à l'émetteur de T13 et son anode connectée à la base de T11. La diode D15 a sa cathode connectée à un des émetteurs de T11 et son anode connectée à la base de T13 et la diode D14 a sa cathode connectée à l'autre émetteur de T11 et son anode connectée à la base de T13.

Le transistor de sortie est disposé comme dans la cellule 10. Donc à la sortie de la cellule 12, prise au collecteur du transistor T14, on obtient:

$$Po=(Pi \otimes Ci) \otimes X Y$$

Le circuit de la cellule 14 est identique à celui de la figure 8B et reçoit en entrée Pi, Ci d'une part, et Pi $\otimes$ Ci, X et Y d'autre part.

Il fournit donc en sortie au collecteur du transistor T14, Co=Pi Ci + X Y (Pi $\otimes$ Ci).

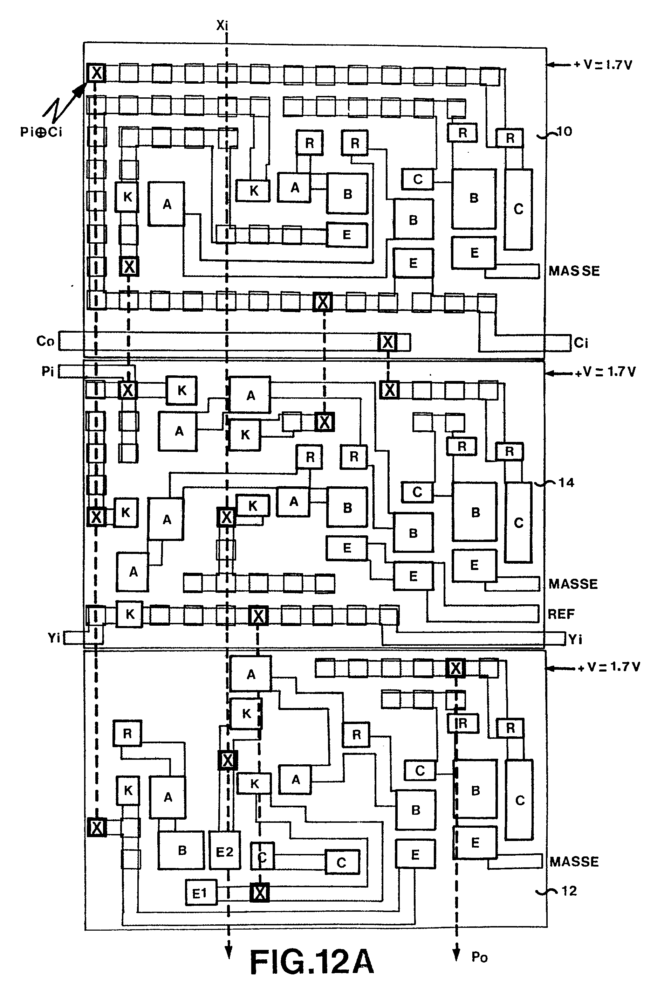

Les connexions correspondantes des éléments des trois cellules sont représentées sur la figure 12A.

Les traits pointillés représentent les connexions au deuxième niveau de métallisation, réalisées dans les canaux de cablage verticaux et permettant d'interconnecter les cellules entre elles et de leur amener les signaux d'entrée X, Y, Pi et Ci.

Ce type de fonction complexe a été représenté, à titre d'exemple, mais il est évident que l'on peut en envisager beaucoup d'autres, par exemple, des arbres de parité constitués de circuits OU exclusif peuvent être réalisés à l'aide de huit cellules, un multiplicateur un bit peut être réalisé en trois cellules, un circuit de prédiction de report pour un additionneur 4 bits peut être réalisé en quatre cellules.

La cellule de type universel représentée sur la figure 5B dans laquelle peuvent être constitués les circuits de la famille DTTL permet de concevoir des réseaux logiques présentant un produit puissance x performance améliorée par rapport aux réseaux logiques constitués à base de cellules NON ET classiques. En effet, de nombreux étages inverseurs sont supprimés et ainsi les chemins sont raccourcis.

De plus, le fait que l'on puisse disposer de fonctions logiques complexes précâblées dans plusieurs cellules, permet de raccourcir le temps nécessaire pour la conception du réseau logique et minimise le nombre de masques à personnaliser. ·

**Revendications**

1. Circuit pour réaliser une fonction logique de base à partir de n signaux d'entrée (A, B . . .) du type comportant n diodes de Schottky à faible barrière (D1 à Dn) ayant des premières électrodes, chacune des électrodes recevant un des n signaux d'entrée, et des secondes électrodes connectées à un nœud commun relié par une première résistance à une première alimentation de tension, et comprenant: un transistor d'entrée (T1) ayant sa base connectée au nœud commun, son collecteur connecté par une seconde résistance implantée à la première alimentation de tension, et son émetteur pouvant être connecté à une tension de référence dont la valeur est égale au niveau bas des signaux d'entrée pour obtenir un circuit présentant une bonne immunité au bruit ou pouvant recevoir un signal d'entrée supplémentaire X lorsque l'immunité au bruit n'est pas critique, un premier transistor inverseur de sortie (T2) dont la base est connectée au collecteur du premier transistor d'entrée, l'émetteur est connecté à une seconde alimentation de tension et son collecteur connecté par une troisième résistance implantée à la première alimentation de tension de telle façon que le niveau de sortie pris au collecteur dudit transistor de sortie représente la fonction logique (A.B.C.) ou $\overline{X}$ (A.B . . .) suivant que l'émetteur du transistor d'entrée est connecté à la tension de référence ou reçoit le signal d'entrée supplémentaire.

2. Circuit selon la revendication 1, caractérisé en ce que la première tension d'alimentation est de 1,7 volt et la seconde tension d'alimentation est de 0 volt.

3. Circuit logique caractérisé en ce qu'il comprend un circuit élémentaire selon la revendication 1 ou 2, dans lequel k diodes d'entrée ont leurs secondes électrodes connectées à la base d'un premier transistor d'entrée, et (n–k) diodes d'entrée ont leurs premières électrodes connectées à la base d'un second transistor d'entrée (T1–2) dont l'émetteur et le collecteur sont connectés à l'émetteur et au collecteur du premier transistor d'entrée, la base dudit second transistor étant connectée à la première alimentation de tension par une quatrième résistance (R12), de telle sorte que le niveau de sortie pris au collecteur du premier transistor de sortie représente la fonction logique:

$$\overline{X} (AB \ldots + CD \ldots );$$

A, B étant les signaux d'entrée appliqués aux premières électrodes des k diodes d'entrée et C, D . . . étant les signaux d'entrée appliqués aux premières électrodes des (n-k) diodes d'entrée.

4. Circuit logique selon la revendication 3, caractérisé en ce que l'émetteur du second transistor d'entrée reçoit un signal d'entrée supplémentaire Y de telle sorte que le niveau de sortie pris au collecteur du premier transistor de sortie représente la fonction logique:

$$\overline{X} (AB \ldots ) + \overline{Y} (CD \ldots )$$

5. Circuit logique selon la revendication 1 caractérisé en ce qu'il comprend plusieurs transistors d'entrée, dont les collecteurs sont connectés ensemble à la base du transistor de sortie, dont les émetteurs reçoivent des signaux d'entrée supplémentaires, et des diodes d'entrée associées à chaque transistor d'entrée, chaque diode d'entrée ayant une première électrode qui reçoit un signal d'entrée et une seconde électrode connectée à la base du transistor d'entrée associé.

6. Circuit logique selon la revendication 1 ou 2 caractérisé en ce qu'il comprend au moins deux circuits logiques élémentaires, le premier recevant sur les premières électrodes de ses diodes d'entrée, des premiers signaux d'entrée (AB . . .) et sur l'émetteur de son transistor d'entrée un signal supplémentaire, et le second recevant sur les secondes électrodes de ses diodes d'entrée des seconds signaux d'entrée (CD . . .) et sur l'émetteur de son transistor d'entrée, un signal supplémentaire Y, dans lesquels les collecteurs des transistors de sortie des premier et second circuits sont connectés ensemble de telle sorte que le niveau de tension pris au collecteur commun desdits transistors représente la fonction logique

$$[\overline{X} (AB \ldots )].[\overline{Y} CD \ldots )]$$

7. Circuit logique selon l'une quelconque des revendications précédentes caractérisé en ce qu'il est réalisé dans une des cellules universelles d'un réseau matriciel de cellules dans une microplaquette semi-conductrice, chaque cellule comportant n diodes d'entrée, au moins six résistances implantées et au moins cinq transistors, qui sont prédiffusés dans la cellule et qui peuvent être interconnectés pour constituer le circuit logique désiré.

8. Circuit logique selon la revendication 7, caractérisé en ce que les éléments prédiffusés sont câblés au premier niveau de métallisation, dans chaque cellule, les autres niveaux de métallisation étant réservés au cablage des cellules entre elles pour constituer des réseaux logiques.

**Patentansprüche**

1. Schaltung für die Ausführung einer logischen Basisfunktion, ausgehend von n Eingangssignalen (A, B . . .) vom Typ mit n Schottky-Dioden mit geringer Schranke (D1 bis Dn) mit ersten Elektroden, von denen jede eines der n Eingangssignale empfängt, und zweiten Elektroden, die an einem gemeinsamen Knoten angeschlossen sind, der über einen ersten Widerstand mit einer ersten Spannungsversorgung verbunden ist, enthalten: einen Eingangstransistor (T1), an dessen Basis ein gemeinsamer Knoten angeschlossen ist, und dessen Kollektor über einen zweiten eingebauten Widerstand mit der ersten Spannungsversorgung verbunden ist, und dessen Emitter an eine Bezugsspannung angeschlossen werden kann, deren Wert gleich dem niedrigen Niveau der Eingangssignale ist, um eine Schaltung zu erhalten, welche unempfindlich gegen Geräusche ist oder welche ein zusätzliches Eingangssignal X aufnehmen kann, wenn die Unempfindlichkeit gegen Geräusche nicht kritisch ist, einen ersten Ausgangsumkehrtransistor (T2), dessen Basis mit dem Kollektor des ersten Eingangstransistors verbunden ist, wenn der Emitter mit einer zweiten Spannungsversorgung verbunden ist und der Kollektor über einen eingebauten dritten Widerstand mit der ersten Spannungsversorgung verbunden ist, sodass das Ausgangsniveau am Kollektor des besagten Ausgangstransistors die logische Funktion (A.B.C.) oder X (A.B . . .) darstellt, je nachdem, ob der Emitter des Eingangssystems an die Zugsspannung angeschlossen ist oder ein zusätzliches Eingangssignal empfängt.

2. Schaltung gemäss Anspruch 1, dadurch gekennzeichnet, dass die erste Spannungsversorgung 1,7 Volt und die zweite Spannungsversorgung 0 Volt beträgt.

3. Logische Schaltung, dadurch gekennzeichnet, dass sie ein Grundelement gemäss Anspruch 1 oder 2 enthält, in dem k Eingangsdioden ihre zweiten Elektroden an die Basis eines ersten Eingangstransistors angeschlossen haben und (n-k) Eingangsdioden ihre ersten Elektroden an die Basis eines zweiten Eingangstransistors (T1−2) angeschlossen haben, deren Emitter und Kollektor an den Emitter und an den Kollektor des ersten Eingangstransistors angeschlossen sind, während die Basis des besagten zweiten Transistors über einen vierten Widerstand (R12) an die erste Spannungsversorgung angeschlossen ist, sodass das Ausgangsniveau am Kollektor des ersten Ausgangstransistors die logische Funktion darstellt:

$$\overline{X} (AB \ldots + CD \ldots);$$

wobei A, B Eingangssignale sind, die an die ersten Elektroden von k Eingangsdioden angelegt werden und C, D . . . die Eingangssignale sind, die an die ersten Dioden der (n-k) Eingangsdioden angelegt werden.

4. Logische Schaltung gemäss Anspruch 3, dadurch gekennzeichnet, dass der Emitter des zweiten Eingangstransistors ein zusätzliches Eingangssignal Y aufnimmt, sodass das Ausgangsniveau am Kollektor des ersten Ausgangstransistors folgende logische Funktion darstellt:

$$\overline{X} (AB \ldots) + \overline{Y}(CD \ldots)$$

5. Logische Schaltung gemäss Anspruch 1, dadurch gekennzeichnet, dass es mehrere Eingangstransistoren umfasst, deren Kollektoren zusammen an der Basis des Ausgangstransistors angeschlossen sind und deren Emitter zusätzliche Eingangssignale empfangen, und Eingangsdioden in Verbindung mit jedem Eingangstransistor, wobei jede Eingangsdiode eine erste Elektrode besitzt, die ein Eingangssignal empfängt und eine zweite Elektrode, die an die Basis des zugeordneten Eingangstransistors angeschlossen ist.

6. Logische Schaltung gemäss Anspruch 1 oder 2, dadurch gekennzeichnet, dass sie mindestens zwei logische Elementarschaltungen enthält, von denen die erste an den ersten Elektroden ihrer Eingangsdioden die ersten Eingangssignale (AB . . .) empfängt und am Emitter ihres Eingangstransistors ein zusätzliches Signal, und die zweite an den zweiten Elektroden ihrer Eingangsdioden zweite Eingangssignale (CD . . .) und am Emitter ihres Eingangstransistors ein zusätzliches Signal Y, in dem die Kollektoren der Ausgangstransistoren der ersten und zweiten Schaltungen so miteinander verbunden sind, dass das Spannungsniveau am gemeinsamen Kollektor der besagten Transistoren die logische Funktion darstellt:

$$[X (AB \ldots)] . [Y CD \ldots)]$$

7. Logische Schaltung nach einem der vorangehenden Ansprüche, dadurch gekennzeichnet, dass sie in einer der Universalzellen eines matriziellen Zellennetzes in einer Halbleitermikroplatte ausgeführt ist, wobei jede Zelle n Eingangsdioden, mindestens sechs eingesetzte Widerstände und mindestens fünf Transistoren enthält, die in der Zelle vorverteilt sind und die miteinander verbunden werden können, um die gewünschte logische Schaltung zu bilden.

8. Logische Schaltung gemäss Anspruch 7, dadurch gekennzeichnet, dass die vorverteilten Elemente in der ersten Metallisierungsebene in jeder Zelle verdrahtet sind, während die anderen Metallisierungsebenen der Verdrahtung der Zellen untereinander vorbehalten sind, um logische Netze zu bilden.

**Claims**

1. A circuit for performing a basic logic function from n input signals (A, B . . .) of the type including n input low-barrier Schottky-diodes (D1−Dn) having first electrodes, each of which receives one of said n input signals, and second electrodes connected to a common node connected through a first resistor to a first supply voltage, and comprising: an input transistor (T1) the base of which is connected to said common node, the collector of which is connected through a second implanted resistor to the first supply voltage, and the emitter of which being able to be connected to a reference voltage the value of which is equel to the low level of the input signal in order to provide a circuit well protected against noise or able to receive an additional input signal X when the noise protection is not critical, a first output inverter transistor (T2) the base of which is connected to the collector of said first input transistor, the emitter of which is connected to a second supply voltage and the collector of which is connected through a third implanted resistor to the first supply voltage, whereby the output level at the collector of said output transistor represents the logic function (A.B.C) or $\overline{X}$ (A.B . . .) according as the input transistor emitter is connected to the reference voltage or receives the additional input signal.

2. A circuit according to claim 1 characterized in that the value of said first supply voltage is 1.7 volts and the value of said second supply voltage is zero volt.

3. A logic circuit characterized in that it includes an elementary circuit according to claim 1 or 2, wherein k input diodes have their second electrodes connected to the base of a first input transistor, and (n-k) input diodes have their first electrodes connected to the base of a second input transistor (T1–2) the emitter and collector of which are connected to the emitter and collector of said first input transistor, with the base of said second transistor being connected to said first supply voltage through a fourth resistor (R12), whereby the output level at the collector of said first output transistor représents the following logic function:

$\overline{X}$ (AB . . .+CD),

with A, B, being the input signals applied to the first electrodes of said k input diodes, and C, D . . . being the input signals applied to the first electrodes of said (n-k) input diodes.

4. A logic circuit according to claim 3 characterized in that the emitter of said second input transistor receives an additional input signal Y, whereby the output level at the collector of said first output transistor représents the following logic function:

$\overline{X}$ (AB . . .)+$\overline{Y}$ (CD . . .)

5. A logic circuit according to claim 1 characterized in that it includes a plurality of input transistors the collectors of which are connected together to the base of said output transistor and the emitters of which receive additional input signals, and input diodes associated with each input transistor, each of said input diodes having a first electrode which receives an input signal and a second electrode which is connected to the base of the associated input transistor.

6. A logic circuit according to claim 1 or 2 characterized in that it includes at least two elementary logic circuits, the first one receiving first input signals (AB . . .) applied to the first electrodes of its input diodes and an additional signal applied to the emitter of its input transistor, and the second one receiving second input signals (CD . . .) applied to the second electrodes of its input diodes and an additional signal Y applied to the emitter of its input transistor, in which the collectors of the output transistors of said first and second circuits are connected together, so that the voltage level at the common collector of said transistors represents the following logic function:

$[\overline{X}$ (AB . . .)] . $[\overline{Y}$ CD . . .)].

7. A logic circuit according to any one of the above claims, characterized in that it is provided in a general-purpose cell of a matrix of cells in a semiconductor master slice, with each cell including n input diodes, at least six implanted resistors and at least, five transistors which are pre-diffused in the cell and can be interconnected to provide the desired logic circuit.

8. A circuit according to claim 7 characterized in that the pre-diffused elements are interconnected at the first level of metallization, within each cell, and in that the others levels of metallization are solely used for interconnecting the cells to provide logic networks.

FIG.1A

FIG.1B

OUT $= \overline{X}(AB+CD)$
OU AB+CD

X OU VREF

**FIG.2**

OUT $=$
$AB.\overline{X} + CD.\overline{y}$

**FIG.3**

FIG.4

**FIG.5A**

**FIG.5B**

+1.7V

R12    R15    R16

D11
A

D12
B

D15
C

T11
D    S

T14
S

ABCD̄

O

0V

# FIG.6B

B                    C

X'

X'              R      R

R

K    A    K    A    B    C

A    B    E    C    E

MASSE

K    X                    X

A                    D

# FIG.6A

**FIG.7B**

**FIG.7A**

**FIG.8B**

**FIG.8A**

**FIG.9B**

**FIG.9A**

FIG.10B

FIG.10A

| | X_3 | X_2 | X_1 | X_0 |
| --- | --- | --- | --- | --- |
| | Y_3 | Y_2 | Y_1 | Y_0 |
| | $X_3Y_0$ | $X_2Y_0$ | $X_1Y_0$ | $X_0Y_0$ |
| $X_3Y_1$ | $X_2Y_1$ | $X_1Y_1$ | $X_0Y_1$ | |
| $X_3Y_2$ | $X_2Y_2$ | $X_1Y_2$ | $X_0Y_2$ | |
| $X_3Y_3$ | $X_2Y_3$ | $X_1Y_3$ | $X_0Y_3$ | |

| $P_7$ | $P_6$ | $P_5$ | $P_4$ | $P_3$ | $P_2$ | $P_1$ | $P_0$ |

# FIG. 11

OU EXCLUSIF 10        OU EXCLUSIF 12

# FIG. 12B

**FIG.12A**